# EUROPEAN PATENT SPECIFICATION

(11) **EP 1 970 479 B1**
(45) Date of publication and mention of the grant of the patent: **11.03.2015**
(21) Application number: 08150360.9
(22) Date of filing: 17.01.2008
(51) Int. Cl.: D06F 39/00

(54) **Control panel and washing machine having the same**
Kontrolltafel und Waschmaschine mit derselben
Panneau de commande et machine à laver l'utilisant

(30) Priority: 12.03.2007 KR 20070024226
(43) Date of publication of application: 17.09.2008
(73) Proprietor: Samsung Electronics Co., Ltd., Suwon-si, Gyeonggi-do, 443-742 (KR)
(72) Inventor: Lee, Yong Sok, Suwon-si Gyeonggi-do (KR)
(74) Representative: Grünecker, Kinkeldey, Stockmair & Schwanhäusser

(56) References cited:
- EP-A- 1 806 446
- EP-A1- 1 542 363
- DE-U1-202004 012 572
- DE-U1-202004 020 673
- GB-A- 2 426 344
- KR-A- 20040 083 672
- US-A- 4 372 054
- US-A- 5 239 152
- US-A- 5 584 563

## Description

### BACKGROUND

### 1. Field

The present invention relates to a control panel and a washing machine having the same. More particularly, the present invention relates to a control panel and a washing machine having the same capable of providing an aesthetic external appearance and of preventing characters and symbols from being erased.

### 2. Description of the Related Art

An electronic device, such as a washing machine, includes a control panel that controls an operation of the electronic device and informs an operational state thereof. Korean Patent Unexamined Publication No. 10-2007-0015302 discloses a washing machine having such a control panel.

The control panel disclosed in the above Publication includes a panel forming a front surface of the control panel, a circuit board installed behind the panel, a plurality of control buttons installed at a front surface of the panel in the form of protrusions, and a plurality of tact switches provided on the circuit board such that the tact switches can be pressed when the user manipulates the control buttons.

A display unit and a plurality of light emitting diodes are installed on the circuit board to display operational states of the washing machine, and a transparent display window is formed on the panel to allow the user to check signals of the display unit and the light emitting diodes. Characters or symbols are printed on the front surface of the panel to allow the user to recognize functions of the control buttons.

However, since the plural control buttons protrude from the front surface of the control panel, there is a difficulty in providing an aesthetic external appearance. In addition, since the characters or the symbols frequently make contact with hands of the user, the characters or the symbols are blurred or erased when the washing machine has been used for a long period of time. In addition, in a case that the device is not used (a power off state), since the characters or the symbols are exposed to the user's eyes, an external appearance of the washing machine is degraded and a control error may occur caused by a mistake of the user.

EP 1 806 446 A2 discloses a control panel for an electronic device which comprises a sensor array capable of sensing a location of the sensor array of a human finger. A corresponding sensor array comprises sensors as for example field effect sensors or capacitive sensors. The sensor array is part of a control panel and there is further a circuit board with indicators emitting light radiation. EP 1806 446 A2 is prior art according to Article 54 (3) EPC.

EP 1 542 363 A1 discloses a key pad for vending machines. There is a transparent front panel and on the backside of this panel a number of labels and price labels are arranged. This means, that the labels are separately arranged between the transparent panel and a translucent film. A source of illumination is also provided and a printed circuit with corresponding electronic components and with a sensor which has dimensions that seem to correspond to those of the standard label of vending machines.

DE 20 2004 020 673 U1 discloses a control panel for an oven with a transparent cover and with sensors directly arranged below this cover. Moreover, there are display units.

GB 2 426 344 A discloses an illuminated proximity sensor. Corresponding proximity sensors are part of a vehicular control device which includes a connector housing, sealing member, a print circuit board, and an exterior trim member. The sealing member further comprises a number of indentations used for receiving illumination elements. Those illumination elements are attached to a surface of the printed circuit board. The indentations have a concave shape which reflects the illuminated light at various angles back toward the printed circuit board. This is semi-translucent for allowing illumination light to pass therethrough. This light is then used as a back light of a plurality of graphics formed on the exterior trim member.

It is an object of the present invention to provide a control panel and an apparatus having same capable of providing an aesthetically pleasing control panel in which the symbols indicating the control functions cannot be erased through use.

This object is solved by the features of claim 1.

Advantageous embodiments are disclosed by the sub claims.

According to an aspect of the present embodiment, the characters or the symbols displayed on the rear surface of the semi-transparent cover may include characters and symbols displaying operational states of the apparatus, and characters or symbols indicating positions of the plural detecting members.

Further, according to an aspect of the present embodiment, the film may be attached to a front surface of the detecting panel, and the detecting panel may be attached to the rear surface of the semi-transparent cover.

The at least one symbol may be an alpha-numeric character.

The control panel may further include a control unit causing the light emitting unit to irradiate the light when an operation of the washing machine is running and stopping the irradiation of the light when the operation ends. The control unit may cause the light emitting unit to irradiate the light when the user touches the cover at a viewable position of the at least one symbol.

### BRIEF DESCRIPTION OF THE DRAWINGS

These and/or other aspects and advantages will become apparent and more readily appreciated from the following description of the embodiment, taken in conjunction with the accompanying drawings of which:
FIG. 1 is a perspective view representing an external appearance of a washing machine having a control panel according to the present embodiment;
FIG. 2 is an exploded perspective view representing a control panel according to the present embodiment; and
FIG. 3 is a sectional view representing a control panel according to the present embodiment.

### DETAILED DESCRIPTION OF THE EMBODIMENTS

Reference will now be made in detail to the embodiment, examples of which are illustrated in the accompanying drawings, wherein like reference numerals refer to the like elements throughout.. The embodiment is described below to explain the present invention by referring to the figures.

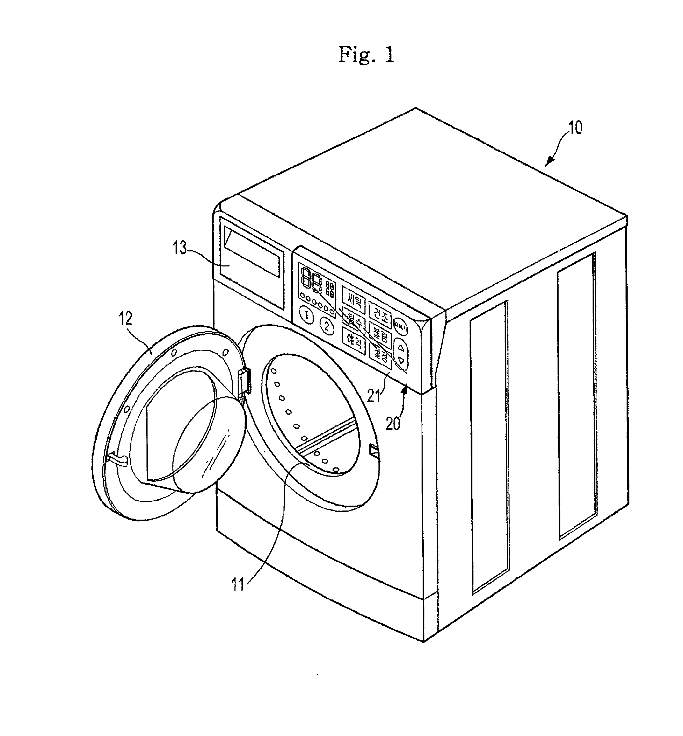

FIG. 1 represents a drum-type washing machine, for example, employing a control panel according to the present embodiment. The washing machine includes a body 10 having an inlet 11 at a front surface thereof to allow a user to input laundry into the body 10, and a door 12 rotatably installed at the front surface of the body 10 to open/close the inlet 11. A detergent supply device 13 that dispenses detergents into the body 10 and a control panel 20 that displays a control state and an operational state of the washing machine are provided on an upper portion of the front surface of the body 10.

Although not shown in the drawings, a tub that contains washing water, a rotational drum rotatably installed in the tub, a driving motor that rotates the rotational drum, a water-supply device that supplies the washing water, and a drain device to perform a drainage operation are provided in the body 10.

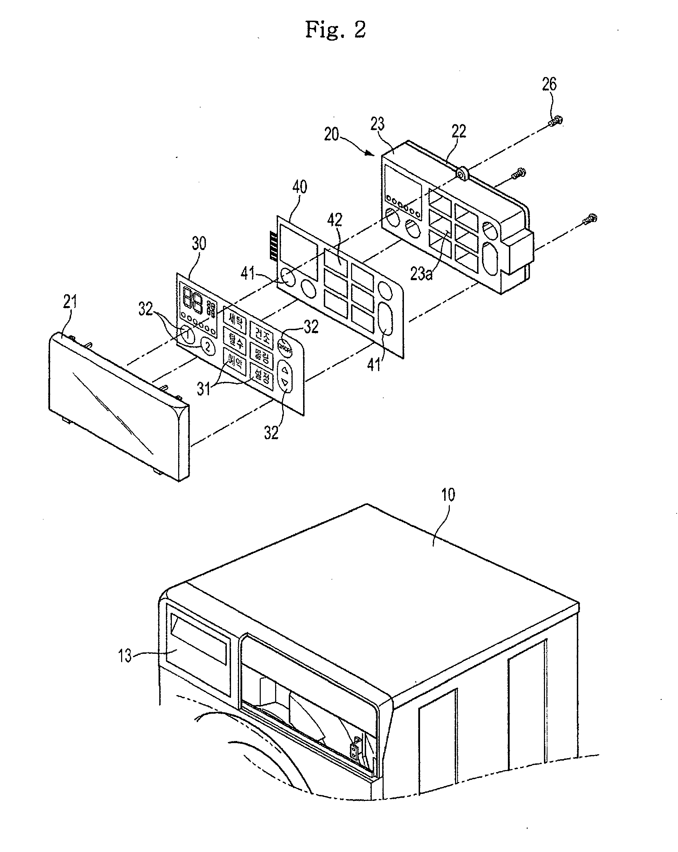

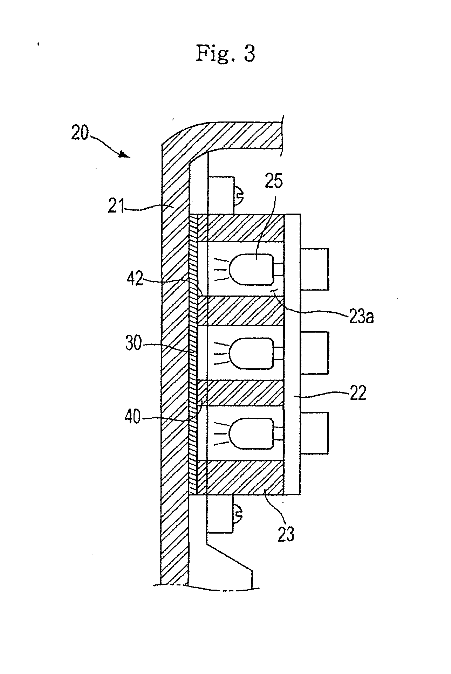

As shown in FIGS. 2 and 3, the control panel 20 installed on the upper portion of the front surface of the body 10 comprises a semi-transparent cover 21, a film 30 printed with characters or symbols 31 and 32, a detecting panel 40 having a plurality of detecting members 41, a circuit board 22 having a plurality of LEDs (light emitting diodes) 25 and a guide member 23 having a plurality of optical paths 23a to guide light.

The semi-transparent cover 21 may include semi-transparent resin or tempered glass. The characters or the symbols 31 and 32 are not printed on a front surface and a rear surface of the semi-transparent cover 21 to provide a simple external appearance.

The film 30 installed behind the semi-transparent cover 21 includes a transparent material that allows light to pass therethrough. The plural characters or symbols 31 and 32 indicating the operational state of the washing machine are printed on the film 30. In addition, the characters or the symbols 31 and 32 indicating the positions of the detecting members 41 of the detecting panel 40 installed behind the film 30 are printed on the film 30.

The detecting panel 40 includes non-contact type detecting members 41 capable of detecting a variable capacitance of a human body. The detecting members 41 are equipped with detecting ICs that detect the capacitance. Thus, when the user touches an outer surface of the semi-transparent cover 21, the detecting members 41 can detect the touch of the user. Such a detecting panel 40 has a structure simpler than that of the conventional control buttons, and a physical force is not applied to the detecting members 41, so a malfunction of the detecting panel 40 rarely occurs as compared with the conventional press-type control buttons.

The detecting panel 40 includes openings 42 allowing light irradiated from the LEDs 25 of the circuit board 22 to pass therethrough, and the openings 42 correspond to the characters or the symbols 31 and 32 of the film 30 installed in front of detecting panel 40. The light irradiated from the LEDs 25 is introduced to the characters or the symbols 31, particularly to the characters or the symbols 31 indicating the operation state.

In addition, the detecting members 41 of the detecting panel 40 correspond to the characters and the symbols 32 indicating the positions of the detecting members 41 among the characters or the symbols on the film 30 provided in front of the detecting panel 40. Openings 42 can be formed in the vicinity of the detecting members 41 or the detecting panel 40 may include a transparent material to allow light to be irradiated to the characters or the symbols 31 and 32 of the film 30 through a region in which the detecting members 41 are positioned.

Each of the LEDs 25 provided on the circuit board 22 individually emit light to irradiate light onto the characters or the symbols 31 and 32 printed on the film 30. To this end, the guide member 23 having the optical paths 23a accommodating the LEDs 25, respectively, is coupled to a front surface of the circuit board 22. That is, the LEDs 25 of the circuit board 22 enter the optical paths 23a of the guide member 23. The optical paths 23a of the guide member 23 correspond to the characters or the symbols 31 and 32 printed on the film 30, respectively. The light of the LEDs 25 is guided through the optical paths 23a to be irradiated to the characters or the symbols 31 and 32, such that the characters and symbols 31 or 32 are projected onto the rear surface of the semi-transparent cover 21. In this manner, as the characters and the symbols 31 or 32 are projected onto the rear surface of the semi-transparent cover 21, the user can check the characters or the symbols 31 and 32 at the front of the semi-transparent cover 21.

When assembling the control panel 20, the film 30 is attached to a front surface of the detecting panel 40 by using double-sided tape (not shown), and the detecting panel 40 is attached to the rear surface of the semi-transparent cover 21 by using the double sided tape. Then, the guide member 23 having the circuit board 22 is coupled to a rear side of the semi-transparent cover 21, and the guide member 23 is fixedly screw-coupled to an inside of the semi-transparent cover 21 by using a plurality of screws 26.

Since power is not applied to the LEDs 25 of the circuit board 22 when the washing machine does not operate, the characters or the symbols 31 and 32 are not displayed at the front surface of the semi-transparent cover 21. That is, in a state in which the operation stops, since the LEDs 25 do not emit light, the characters or the symbols 31 and 32 are not projected onto the rear surface of the semi-transparent cover 21, thereby providing an aesthetic and simple external appearance. At this time, the characters or the symbols 31 and 32 indicating the positions of the detecting members 41 of the detecting panel 40 are not displayed.

When power is applied to the washing machine, the LEDs 25 emit light such that the characters or the symbols 31 and 32, which indicate the positions of the detecting members 41, are projected onto the rear surface of the semi-transparent cover 21. Accordingly, the user can set operational conditions or functions of the washing machine, while checking the control positions displayed on the front surface of the semi-transparent cover 21. When the user touches the front surface of the semi-transparent cover 21, the detecting member 41 of the detecting panel 40 detects a capacitance of the human body, thereby detecting the user's control. Further, if a function is selected in this manner, the LED 25 corresponding to the characters or symbols 31 and 32 emits the light, so the corresponding characters or symbols 31 and 32 are displayed on the semi-transparent cover 21. Since the characters or the symbols 31 and 32 indicating other functions or operation states are not displayed, the user may precisely know the operational state. Accordingly, the control error can be reduced.

As described above, according to the present embodiment, since the function of the control panel is controlled by touching the outer surface of the semi-transparent cover, the control panel represents a simple structure having an aesthetic external appearance as compared with the conventional control panel. In particular, when the operation of the apparatus stops or the control function is not used, since the characters or the symbols are not displayed on the semi-transparent cover, the aesthetic appearance is improved and the control error is reduced.

In addition, according to the present embodiment, since the control panel displays the characters or the symbols in such a manner that the characters or the symbols printed on the film are projected onto the rear surface of the semi-transparent cover by means of the emission of the LED, the characters or the symbols are prevented from being erased even if the washing machine is used for a long period of time.

Although an embodiment has been shown and described, it would be appreciated by those skilled in the art that changes may be made in this embodiment without departing from the principles of the invention, the scope of which is defined in the claims.

## Claims

1. A control panel (20) to control an operation of an apparatus, the control panel (20) comprising:
a detecting panel (40) having a plurality of detecting members (41) detecting a capacitance of the user;
a circuit board (22) having a light emitting unit irradiating light, the light emitting unit including a plurality of light emitting diodes (25),
**characterized by**
a semi-transparent cover (21) to receive the user's touch;
a film (30) disposed behind said cover (21) having a plurality of characters or symbols (31, 32) printed thereon, the characters or symbols (31, 32) being viewable through the cover (21), the detecting panel (40) being disposed behind said film (30), wherein said detecting members (41) correspond to each of the characters or symbols (31, 32) to detect the capacitance of the user when the user touches the cover (21) at the characters or symbols (31, 32) and wherein said light emitting unit irradiates light onto the film (30) and causes the characters or symbols (31, 32) to be displayed on the cover (21); and
a guide member (23) having a plurality of optical paths (23a) which correspond to the characters or the symbols (31, 32) printed on the film (30), the guide member (23) being coupled to a front surface of the circuit board (22) and the plurality of light emitting diodes (25) being disposed in the optical paths, respectively, such that said light irradiated individually from each of the light emitting diodes (25) is guided onto each of the characters or the symbols (31, 32) of the film (30), wherein the plurality of light emitting diodes (25) is installed on the front surface of the circuit board (22) and the guide member (23) is disposed between the detecting panel (40) and the circuit board (22).

2. The control panel according to claim 1, **characterized in that** the characters or the symbols (31, 32) displayed on the rear surface of the semi-transparent cover (21) include characters or symbols (31 ,32) displaying operational states of the apparatus (10) and characters or symbols (31, 32) indicating positions of the detecting members (41).

3. The control panel according to claim 1, **characterized in that** the film (30) is attached to a front surface of the detecting panel (40) and the detecting panel (40) is attached to the rear surface of the semi-transparent cover (21).

4. The control panel according to claim 1, **characterized in that** the panel (20) comprises a control unit causing the light emitting unit to irradiate the light when an operation of the apparatus (10) is running and stopping the irradiation of the light when the operation ends.

5. The control panel according to claim 1, **characterized in that** said panel (20) further comprises a control unit causing the light emitting unit to irradiate the light when the user touches the cover (21) at a viewable position of the at least one symbol.

6. An apparatus **characterized by** a control panel (20) to control an operation of the apparatus according to one of the previous claims.

## Patentansprüche

1. Steuerpanel (20) zum Steuern des Betriebs einer Vorrichtung, wobei das Steuerpanel (20) umfasst:
ein Erfassungspanel (40) mit einer Vielzahl von Erfassungsgliedern (41), die die Kapazität eines Benutzers erfassen,
eine Leiterplatte (22) mit einer Lichtemissionseinheit zum Ausstrahlen von Licht, wobei die Lichtemissionseinheit eine Vielzahl von Licht emittierenden Dioden (25) umfasst,
**gekennzeichnet durch**
eine semitransparente Abdeckung (21) zum Empfangen einer Berührung des Benutzers,
eine Folie (30), die hinter der Abdeckung (21) angeordnet ist und eine Vielzahl von darauf gedruckten Zeichen oder Symbolen (31, 32) aufweist, wobei die Zeichen oder Symbole (31, 32) **durch** die Abdeckung (21) hindurch sichtbar sind, wobei das Erfassungspanel (40) hinter der Folie (30) angeordnet ist, wobei die Erfassungsglieder (41) jeweils den Zeichen oder Symbolen (31, 32) entsprechen, um die Kapazität des Benutzers zu erfassen, wenn der Benutzer die Abdeckung (21) an den Zeichen oder Symbolen (31, 32) berührt, und wobei die Lichtemissionseinheit Licht auf die Folie (30) strahlt und veranlasst, dass die Zeichen oder Symbole (31, 32) auf der Abdeckung (21) angezeigt werden, und
ein Führungsglied (23), das eine Vielzahl von optischen Pfaden (23a) aufweist, die den auf die Folie (30) gedruckten Zeichen oder Symbolen (31 32) entsprechen, wobei das Führungsglied (23) mit einer vorderen Fläche der Leiterplatte (22) gekoppelt ist und die Vielzahl von Licht emittierenden Dioden (25) jeweils in den optischen Pfaden angeordnet sind, sodass das von jeder der Licht emittierenden Dioden (25) individuell ausgestrahlte Licht jeweils auf eines der Zeichen oder Symbole (31, 32) der Folie (30) geführt wird, wobei die Vielzahl von Licht emittierenden Dioden (25) auf der vorderen Fläche der Leiterplatte (22) installiert sind und das Führungsglied (23) zwischen dem Erfassungspanel (40) und der Leiterplatte (22) angeordnet ist.

2. Steuerpanel nach Anspruch 1, **dadurch gekennzeichnet, dass** die Zeichen oder Symbole (31, 32), die auf der hinteren Fläche der semitransparenten Abdeckung (21) angezeigt werden, Zeichen oder Symbole (31, 32) zum Anzeigen von Betriebszuständen der Vorrichtung (10) und Zeichen oder Symbole (31, 32) zum Angeben von Positionen der Erfassungsglieder (41) umfassen.

3. Steuerpanel nach Anspruch 1, **dadurch gekennzeichnet, dass** die Folie (30) an der vorderen Fläche des Erfassungspanels (40) angebracht ist und das Erfassungspanel (40) an der hinteren Fläche der semitransparenten Abdeckung (21) angebracht ist.

4. Steuerpanel nach Anspruch 1, **dadurch gekennzeichnet, dass** das Panel (20) eine Steuereinheit umfasst, die veranlasst, dass die Lichtemissionseinheit das Licht ausstrahlt, wenn der Betrieb der Vorrichtung (10) läuft, und das Ausstrahlen des Lichts beendet, wenn der Betrieb endet.

5. Steuerpanel nach Anspruch 1, **dadurch gekennzeichnet, dass** das Panel (20) weiterhin eine Steuereinheit umfasst, die veranlasst, dass die Lichtemissionseinheit das Licht ausstrahlt, wenn der Benutzer die Abdeckung (21) an einer sichtbaren Position des wenigstens einen Symbols berührt.

6. Vorrichtung, **gekennzeichnet durch** ein Steuerpanel (20) zum Steuern des Betriebs der Vorrichtung gemäß einem der vorstehenden Ansprüche.

## Revendications

1. Panneau de contrôle (20) pour contrôler une opération d'un appareil, le panneau de contrôle (20) comprenant :
un panneau de détection (40) comportant une pluralité d'éléments de détection (41) qui détectent une capacitance de l'utilisateur ;
un circuit imprimé (22) comportant une unité d'émission de lumière qui irradie de la lumière, l'unité d'émission de lumière comportant une pluralité de diodes électroluminescentes (25),
**caractérisé par**
un couvercle semi-transparent (21) pour recevoir une entrée tactile de l'utilisateur ;
un film (30) agencé derrière ledit couvercle (21) sur lequel sont imprimés une pluralité de caractères ou de symboles (31, 32), les caractères ou symboles (31, 32) étant visibles à travers le couvercle (21), le panneau de détection (40) étant agencé derrière ledit film (30), dans lequel lesdits éléments de détection (41) correspondent à chacun des caractères ou symboles (31, 32) pour détecter la capacitance de l'utilisateur quand l'utilisateur touche le couvercle (21) sur les caractères ou symboles (31, 32), et dans lequel ladite unité d'émission lumineuse irradie de la lumière sur le film (30) et provoque l'affichage des caractères ou symboles (31, 32) sur le couvercle (21) ; et
un élément de guidage (23) comportant une pluralité de chemins optiques (23a) qui correspondent aux caractères ou symboles (31, 32) imprimés sur le film (30), l'élément de guidage (23) étant couplé à une surface avant du circuit imprimé (22) et les diodes de la pluralité de diodes électroluminescentes (25) étant respectivement agencées dans les chemins optiques de telle sorte que ladite lumière irradiée individuellement par chacune des diodes électroluminescentes (25) est guidée sur chacun des caractères ou symboles (31, 32) du film (30), dans lequel la pluralité de diodes électroluminescentes (25) est installée sur la surface avant du circuit imprimé (22) et l'élément de guidage (23) est agencé entre le panneau de détection (40) et le circuit imprimé (22).

2. Panneau de contrôle selon la revendication 1, **caractérisé en ce que** les caractères ou symboles (31, 32) affichés sur la surface arrière du couvercle semi-transparent (21) comprennent des caractères ou symboles (31, 32) qui affichent des états opérationnels de l'appareil (10) et des caractères ou symboles (31, 32) qui indiquent des positions des éléments de détection (41).

3. Panneau de contrôle selon la revendication 1, **caractérisé en ce que** le film (30) est fixé à une surface avant du panneau de détection (40) et **en ce que** le panneau de détection (40) est fixé à la surface arrière du couvercle semi-transparent (21).

4. Panneau de contrôle selon la revendication 1, **caractérisé en ce que** le panneau (20) comprend une unité de contrôle qui commande à l'unité d'émission lumineuse d'irradier la lumière quand une opération de l'appareil (10) est en marche et qui arrête l'irradiation de la lumière quand l'opération se termine.

5. Panneau de contrôle selon la revendication 1, **caractérisé en ce que** ledit panneau (20) comprend en outre une unité de contrôle qui commande à l'unité d'émission lumineuse d'irradier la lumière quand l'utilisateur touche le couvercle (21) à une position visible dudit au moins un symbole.

6. Appareil **caractérisé par** un panneau de contrôle (20) pour contrôler une opération de l'appareil selon l'une des revendications précédentes.
